# EUROPÄISCHE PATENTANMELDUNG

(11) **EP 4 776 000 A1**
(43) Veröffentlichungstag der Anmeldung: **15.07.2026**
(21) Anmeldenummer: 25222138.7
(22) Anmeldetag: 10.12.2025
(51) Int. Cl.: G01R 27/08

(54) **VERFAHREN UND VORRICHTUNG ZUR FLÄCHIGEN ERFASSUNG VON MESSDATEN**

(30) Priorität: 17.12.2024 DE 102024138209
(71) Anmelder: Deutsches Zentrum für Luft- und Raumfahrt e.V., 53227 Bonn (DE)
(72) Erfinder: Klingenberg, Florian, 53227 Bonn (DE); Riehmer, Johannes, 53227 Bonn (DE)
(74) Vertreter: dompatent

(57) **Zusammenfassung**

Verfahren und Vorrichtung zur Erfassung von flächigen Messdaten, insbesondere von einer flächigen Temperaturverteilung, wobei das Verfahren die Schritte aufweist: Bereitstellen eines Netzwerks von einzelnen Widerstandsensoren; Bereitstellen einer Datenerfassungseinheit, wobei die Datenerfassungseinheit mit dem Netzwerk von Widerstandssensoren verbunden ist zur Erfassung eines oder mehrerer Widerstandswerte über dem gesamten Netzwerk von Widerstandssensoren umfasst; Bereitstellen eines trainierten künstlichen neuronalen Netzes in der Datenerfassungseinheit, zur Bestimmung der Widerstandswerte der einzelnen Widerstandssensoren aus dem einen oder mehreren Widerstandswerten des gesamten Netzwerks von Widerstandssensoren; und Bestimmen durch das künstliche neuronale Netz der Widerstandswerte der einzelnen Widerstandssensoren aus den erfassten ein oder mehreren Widerstandswerten des gesamten Netzwerks von Widerstandssensoren.

## Beschreibung

Die vorliegende Erfindung betrifft eine Vorrichtung und ein Verfahren zur flächigen Erfassung von Messdaten, insbesondere von einer flächigen Temperaturverteilung.

Aus dem Stand der Technik sind Messverfahren und -vorrichtung zur Erfassung von flächigen Messdaten, insbesondere Temperaturdaten, bekannt, bspw. die Infrarot-Thermografie oder Temperaturempfindliche Farben. Beide Messverfahren sind abhängig von der Oberflächenbeschaffenheit bzw. den Materialeigenschaften und erfordern in der Regel zunächst eine spezielle Oberflächenbehandlung. Zudem ist eine optische Zugänglichkeit der Messstelle erforderlich. Schließlich sind die Beschaffung und die Anwendung mit hohen Kosten verbunden, so dass diese Verfahren vorrangig in experimentellen Untersuchungen oder im Rahmen von Wartungen zur Anwendung kommen.

Alternativ können flächige Messdaten über Punktmessungen erfasst werden, bspw. Widerstandsthermometer oder Thermoelemente, wobei eine entsprechend große Anzahl an Messelementen auf der zu vermessenden Fläche angebracht wird. Nachteilig hierbei ist der zur Datenerfassung erforderliche Aufwand zur Verkabelung der einzelnen Messelemente, samt Stecker und Anschlüssen, und die Anzahl an Datenerfassungskanälen.

Ausgehend von den vorbezeichneten Nachteilen des Stands der Technik stellt sich die vorliegende Erfindung die Aufgabe ein Verfahren und eine Vorrichtung zur flächigen Erfassung von Messdaten bereit zu stellen, wobei der erforderliche Aufwand zur Verkabelung und die Anzahl der Datenerfassungskanäle reduziert ist, ohne die Anzahl an Messelementen und damit die flächige Auflösung einzuschränken.

Gemäß einem ersten Aspekt der vorliegenden Erfindung wird ein Verfahren zur Erfassung von flächigen Messdaten, insbesondere von einer flächigen Temperaturverteilung, bereitgestellt mit den Schritten:
Bereitstellen eines Netzwerks von einzelnen Widerstandsensoren;
Bereitstellen einer Datenerfassungseinheit, wobei die Datenerfassungseinheit mit dem Netzwerk von Widerstandssensoren verbunden ist zur Erfassung eines oder mehrerer Widerstandswerte über dem gesamten Netzwerk von Widerstandssensoren;
Bereitstellen eines trainierten künstlichen neuronalen Netzes (KNN) in der Datenerfassungseinheit, zur Bestimmung der Widerstandswerte der einzelnen Widerstandssensoren aus dem einen oder mehreren Widerstandswerten des gesamten Netzwerks von Widerstandssensoren; und
Bestimmen durch das trainierte künstliche neuronale Netz der Widerstandswerte der einzelnen Widerstandssensoren aus den erfassten ein oder mehreren Widerstandswerten des gesamten Netzwerks von Widerstandssensoren.

Hierbei handelt es sich um ein computerimplementiertes künstliches neuronales Netz. Die Datenerfassungseinheit misst den Widerstandswert über mehrere Widerstandssensoren des Netzwerks gemeinsam. Aus den so ermittelten Widerstandswerten für das gesamte Netzwerk kann sodann durch das künstliche neuronale Netz die Widerstandswerte der einzelnen Widerstandssensoren ermittelt werden. Bevorzugt ist die Anzahl an erforderlichen Messungen kleiner als die Anzahl an Widerstandssensoren im Netzwerk, also die Anzahl an durch die Datenerfassungseinheit ermittelten Widerstandswerte für das gesamte Netz, kleiner als die Anzahl der Widerstandssensoren im Netzwerk bzw. kleiner als die Anzahl der aus dem Widerstandswerte für das gesamte Netz ermittelten Widerstandswerte der einzelnen Widerstandssensoren. Hierbei müssen nicht für alle im Netzwerk vorhandenen Widerstandssensoren ein Widerstandswert durch die Datenerfassungseinheit ermittelt werden. Insbesondere wird durch das künstliche neuronale Netz für jeden der Widerstandssensoren im Netzwerk ein Widerstandswert ermittelt aus den durch die Datenerfassungseinheit bestimmten Widerstandswerten für das gesamte Netzwerk. Somit sind nicht jeweils die Widerstandssensoren einzeln und separat mit der Datenerfassungseinheit verbunden zur einzelnen Messung derer Widerstände. Es werden somit für die Erfassung der Messdaten deutlich weniger Datenkanäle benötigt sowie der Aufwand zur Verkabelung erheblich reduziert im Vergleich zum Stand der Technik.

Vorzugsweise verfügt die Datenerfassungseinheit über mindestens einen mit dem Netzwerk verbundenen Ausgang und mindestens einen mit dem Netzwerk verbundenen Eingang. Vorzugsweise sind der mindestens eine Ausgang mit einer Ausgangskontaktstelle des Netzwerks verbunden und der mindestens eine Eingang der Datenerfassungseinheit mit einer Eingangskontaktstelle des Netzwerks verbunden. Insbesondere bezeichnen die Eingangskontaktstelle bzw. die Ausgangskontaktstelle Knotenpunkte des Netzwerks, an denen der mindestens eine Eingang bzw. der mindestens eine Ausgang der Datenerfassungseinheit mit dem Netzwerk verbunden ist. Insbesondere wird mittels der Datenerfassungseinheit ein Widerstandwert zwischen der Eingangskontaktstelle und der Ausgangskontaktstelle für das gesamte Netzwerk von Widerstandssensoren erfasst. Somit werden die Anzahl der erforderlichen Messungen reduziert.

Vorzugsweise weist die Datenerfassung mehrere Ausgänge und/oder mehrere Eingänge auf. Dabei können oder sind die mehreren Ausgänge mit entsprechenden Ausgangskontaktstellen des Netzwerks verbunden. Ebenso sind die mehreren Eingänge mit entsprechenden Eingangskontaktstellen verbunden. Dabei sind insbesondere alle Eingangskontaktstellen verschieden. Dabei sind insbesondere alle Ausgangskontaktstellen verschieden.

Vorzugsweise sind alle Eingangskontaktstellen verschieden von allen Ausgangstellen. Alternativ sind mindestens eine oder mehrere Eingangskontaktstellen, insbesondere alle Eingangskontaktstellen, identisch mit den Ausgangskontaktstellen. Somit kann der mindestens eine Eingang der Datenerfassungseinheit auch als Ausgang verwendet werden und der mindestens eine Ausgang der Datenerfassungseinheit auch als Eingang verwendet werden. Insbesondere ist für eine Messung die mit der Datenerfassungseinheit verbundene Eingangskontaktstelle verschieden von der mit der Datenerfassungseinheit verbundenen Ausgangskontaktstelle.

Bevorzugt werden eine Vielzahl an Messungen durchgeführt, insbesondere sequenzielle Messungen oder parallele Messungen, wobei in jeder Messung mindestens ein Widerstandswert für das gesamte Netzwerk von Widerstandssensoren erfasst wird, so dass das trainierte künstliche neuronale Netz aus der Vielzahl an Widerstandswerten des gesamten Netzwerks die Widerstandswerte der einzelnen Widerstandssensoren des Netzwerks von Widerstandssensoren ermitteln kann. Hierzu wird die Datenerfassungseinheit für jede der Vielzahl von Messungen, insbesondere sequenziell, mit einer anderen Ausgangskontaktstellen und/oder einer anderen Eingangskontaktstelle des Netzwerks von Widerstandssensoren verbunden. Insbesondere ist für eine Messung die mit der Datenerfassungseinheit verbundene Eingangskontaktstelle verschieden von der mit der Datenerfassungseinheit verbundenen Ausgangskontaktstelle. Es wird somit für eine Kombination aus einer bestimmten Ausgangskontaktstelle und einer bestimmten, von der Ausgangskontaktstelle verschiedenen, Eingangskontaktstelle mindestens ein Widerstandswert für das gesamte Netzwerk ermittelt. Nachfolgend wird ein Widerstandswert für eine weitere Kombination aus Eingangskontaktstelle und Ausgangskontaktstelle verwendet zur Bestimmung des Widerstandswertes des gesamten Netzwerks. Somit können mehrere Widerstandswerte des gesamten Netzwerks von Widerstandssensoren erfasst werden, wobei das Netzwerk von Widerstandssensoren unverändert bleibt. Die Frequenz der Vielzahl an sequenziellen Messungen kann hierbei insbesondere an die Trägheit des zu messenden physikalischen Wertes angepasst werden.

Bevorzugt umfasst die Bereitstellung des trainierten künstlichen neuronalen Netzes zusätzlich die Schritte:
Bereitstellen eines digitalen Abbildes des Netzwerks von Widerstandssensoren;
Generieren einer Datenbank aus einer Vielzahl von unterschiedlichen Widerstandswerten der einzelnen Widerstandssensoren mit den dazugehörigen Widerstandswerten des gesamten Netzwerks von Widerstandssensoren mittels Simulation mit dem digitalen Abbild des Netzwerks;
Bereitstellen eines untrainierten künstlichen neuronalen Netzes; und Trainieren des künstlichen neuronalen Netzes mit den Widerstandswerten des gesamten Netzwerks von Widerstandssensoren und den Widerstandswerten der einzelnen Widerstandssensoren aus der Datenbank.

Vorzugsweise umfasst das digitale Abbild zusätzlich eine Vielzahl an Ausgangs-und Eingangskontaktstellen des Netzwerks von Widerstandssensoren mit denen der mindestens eine Ausgang und der mindestens eine Eingang der Datenerfassungseinheit verbunden wird. Insbesondere werden für jeden einzelnen Widerstandssensor verschiedene Widerstandswerte simuliert und jeweils der resultierende Widerstandswert des gesamten Netzwerks von Widerstandssensoren zwischen der Vielzahl an Ausgangskontaktstellen und/oder der Vielzahl an Eingangskontaktstellen bestimmt. Dabei entsprechend die Vielzahl an Ausgangskontaktstellen und/oder der Vielzahl an Eingangskontaktstellen den Ausgangskontaktstellen und Eingangskontaktstellen des später für die Messung verwendeten Netzwerks von Widerstandssensoren. Hierbei bleibt das Netzwerk von Widerstandssensoren unverändert. Vorzugsweise können zusätzlich neben den Widerstandswerten der einzelnen Widerstandssensoren oder stattdessen die vom Widerstandssensor zu messende physikalische Größe, insbesondere eine Temperatur oder ein Druck oder eine Längenausdehnung, an der Messstelle des einzelnen Widerstandssensors simuliert werden. Vorzugsweise erfolgt das Bereitstellen eines digitalen Abbildes und die Simulation des Netzwerks von Widerstandssensoren in einer Softwareumgebung, bspw. LTSpice. Alternativ zu einem Training mit synthetischen Daten aus einer Simulation kann das Training des künstlichen neuronalen Netzes insbesondere mit realen Messwerten durchgeführt werden. Hierbei werden die einzelnen Widerstandssensoren vermessen, bei jeder Messung der Datenerfassungseinheit des Widerstandswertes des gesamten Netzwerks.

Vorzugsweise sind die Widerstandssensoren des Netzwerks unterschiedlich ausgebildet und können an die Erfordernisse der Messung angepasst werden, wie beispielsweise eine zu erwartende Temperaturverteilung über das Netzwerk. Alternativ sind alle Widerstandssensoren identisch ausgebildet.

Vorzugsweise ist die Anzahl an mit der Datenerfassungseinheit verbundenen Ausgangskontaktstellen und Eingangskontaktstelle des Netzwerks von Widerstandssensoren, insbesondere das Produkt aus der Anzahl an Ausgangs- und Eingangskontaktstellen, kleiner als die Anzahl der Widerstandssensoren im Netzwerk. Somit ist die Anzahl an möglichen unterschiedlichen Messungen von Widerstandswerten des gesamten Netzwerks kleiner als die Anzahl an Widerstandssensoren im Netzwerk.

Bevorzugt sind die Ausgänge der Datenerfassungseinheit durch einen ersten Multiplexer bereitgestellt und die Eingänge der Datenerfassungseinheit durch einen zweiten Multiplexer. Der erste Multiplexer verfügt über mindestens einen Ausgang, insbesondere eine Vielzahl an Ausgängen, wobei die Datenerfassungseinheit über den mindestens einen Ausgang mit dem Netzwerk von Widerstandssensoren an den Ausgangskontaktstellen verbunden ist. Der zweite Multiplexer verfügt über mindestens einen Eingang, insbesondere über eine Vielzahl an Eingängen, wobei der mindestens einen Eingang mit dem Netzwerk von Widerstandssensoren an den Eingangskontaktstellen verbunden ist. Die Verbindung mit dem Netzwerk kann ausgebildet sein, um verschiedene Abschnitte von einzelnen Widerstandssensoren zwischen einer mit dem mindestens einen Ausgang des ersten Multiplexers verbundenen Ausgangskontaktstelle und des mindestens einen Eingangs des zweiten Multiplexers verbundenen Eingangskontaktstelle zu erfassen. Hierbei können die Anzahl an Ausgängen des ersten Multiplexers mit der Anzahl an Eingängen des zweiten Multiplexers übereinstimmen oder unterschiedlich sein. Insbesondere kann die Anzahl an Ausgängen des ersten Multiplexers größer oder kleiner als die Anzahl an Eingängen des zweiten Mutliplexers sein.

Bevorzugt umfasst das Verfahren zusätzlich die Schritte Messen mindestens eines oder mehrerer Widerstandswerte des gesamten Netzwerks von Widerstandssensoren und Wiederholen der Messung bei unterschiedlichen Kombinationen der Ausgangskontaktstellen und Eingangskontaktstellen des Netzwerks von Widerstandssensoren. Hierbei steuert insbesondere eine Steuereinheit den ersten und den zweiten Multiplexer sowie die Datenerfassungseinheit zur Erfassung des Widerstandswertes über dem gesamten Netzwerk von Widerstandssensoren. Insbesondere werden durch die Steuereinheit eine Vielzahl an Messungen durchgeführt, insbesondere sequenziellen Messungen, und somit über die Vielzahl von Kombinationen an Aus- und Eingängen eine Vielzahl an Widerstandswerten des gesamten Netzwerks zwischen den verschiedenen Ausgangs- und Eingangskontaktstellen erfasst. Das Netzwerk von Widerstandssensoren bleibt unverändert. Durch Ansteuerung unterschiedlicher Kombinationen von Aus- und Eingängen der Multiplexer können anderen Ausgangskontaktstellen und Eingangskontaktstellen des Netzwerks erfasst werden, so dass unterschiedliche Widerstandswerte des gesamten Netzwerks von Widerstandssensoren gemessen werden.

Bevorzugt umfasst die Datenerfassungseinheit zusätzlich eine Spannungsquelle oder eine Stromquelle. Hierbei wird die Spannungsquelle oder Stromquelle insbesondere mit dem ersten Multiplexer verbunden. Die Datenerfassungseinheit erfasst den Widerstandswert des gesamten Netzwerks von Widerstandssensoren insbesondere durch Messung einer Stromstärke bei Verwendung einer Spannungsquelle oder insbesondere durch Messung einer Spannung bei Verwendung einer Stromquelle.

Bevorzugt sind die Widerstandssensoren parallel zu einem Knotenpunkt des Netzwerks von Widerstandssensoren ausgebildet oder die Widerstandssensoren sind als Verbindungsstücke bzw. Kanten zwischen den Knotenpunkten des Netzwerks von Widerstandssensoren ausgebbildet. Somit wird der Messwert über einem Knotenpunkt des Netzwerks erfasst oder zwischen zwei Knotenpunkten des Netzwerks erfasst. Vorzugsweise können zusätzlich Dioden im Netzwerk von Widerstandssensoren verbaut werden, insbesondere unmittelbar parallel zu den Widerstandssensoren. Dadurch wird die Stromrichtung durch das Netzwerk von Widerstandssensoren beeinflusst und der Stromfluss geleitet. Hierdurch lässt sich die Genauigkeit der Messdatenerfassung weiter steigern.

Bevorzugt sind die Widerstandssensoren als Widerstandsthermometer zur Erfassung von Temperaturen ausgebildet. Die Temperaturmessung mittels Widerstandsthermometer ist besonders für eine sequenzielle Messung geeignet, da die physikalische Reaktionszeit über der messtechnischen Aufnahmezeit liegt.

Bevorzugt sind die Widerstandssensoren als Dehnmessstreifen zur Erfassung von Dehnungen ausgebildet. Somit ist die Erfassung von flächigen Messdaten nicht auf Temperaturmessungen beschränkt, sondern insbesondere auch für die Erfassung von strukturellen Bauteiländerung geeignet.

Bevorzugt sind die Widerstandssensoren als Drähte zur Erfassung von strukturellem Versagen oder Rissen ausgebildet. Hierbei werden strukturelle Bauteiländerungen über die Widerstandsänderungen von Drähten, insbesondere dünnen Drähten, erfasst.

Bevorzugt sind die Widerstandssensoren als Druck- oder Kontaktsensoren zur Erfassung von Bauteilberührungen oder Beaufschlagungen mit Gasdruck ausgebildet.

Bevorzugt ist eine Netztopologie des Netzwerks von Widerstandssensoren als regelmäßig geformtes Viereck oder regelmäßig geformtes beliebiges Netzwerk oder als chaotisches Netzwerk ausgebildet. Hierbei ist das Netzwerk von Widerstandssensoren als ein Verbund von Widerstandssensoren ausgebildet. Ein beliebig geformtes Netzwerk ist bspw. als Dreiecksnetz ausgebildet, wobei ein chaotisches Netzwerk bspw. aus unterschiedlichen Vielecken ausgebildet ist. Somit kann die Netztopologie an die Anforderungen der Messdatenerfassung angepasst werden.

Ein zweiter Aspekt der vorliegenden Erfindung betrifft eine Vorrichtung mit einer implementierten Datenerfassungseinheit zur Erfassung von flächigen Messdaten und/oder zur Signalkonditionierung. Hierbei ist die Vorrichtung dazu ausgebildet, flächige Messdaten zu erfassen.

Vorzugsweise ist die Vorrichtung weitergebildet anhand der Merkmale des vorstehend beschriebenen Verfahrens.

Bevorzugt umfasst die Vorrichtung zusätzlich einen Prozessor zur Ausführung des Verfahrens zur Erfassung von flächigen Messdaten. Vorzugsweise umfasst die Vorrichtung zusätzlich einen Datenspeicher, der Instruktionen speichert, insbesondere Prozeduren zur Ausführung der einzelnen Verfahrensschritte. Insbesondere werden auf dem Datenspeicher die Messwerte der Datenerfassungseinheit gespeichert.

Bevorzugt wird durch den Prozessor und/oder den Speicher das künstliche neuronale Netz implementiert.

Im Folgenden werden unter Bezugnahme auf die beigefügten Figuren erfindungsgemäße Ausführungsformen näher erläutert.

Es zeigen:
Fig 1 eine schematische Darstellung eines Verfahrens zur Messung von flächigen Messdaten gemäß einer beispielhaften Ausführungsform der vorliegenden Erfindung;
Fig. 2A eine schematische Darstellung von Widerstandssensoren parallel zu einem Knotenpunkt des Netzwerks von Widerstandssensoren gemäß einer beispielhaften Ausführungsform der vorliegenden Erfindung;
Fig. 2B eine schematische Darstellung von Widerstandssensoren als Verbindungsstücke zwischen den Knotenpunkten eines Netzwerks von Widerstandssensoren als regelmäßig geformtes Viereck gemäß einer beispielhaften Ausführungsform der vorliegenden Erfindung;
Fig. 3 eine schematische Darstellung einer chaotischen Netztopologie gemäß einer beispielhaften Ausführungsform der vorliegenden Erfindung;
Fig. 4 eine schematische Darstellung einer Vorrichtung zur flächigen Messdatenerfassung in einer beispielhaften Ausführungsform gemäß einem weiteren Aspekt der vorliegenden Erfindung;

Gleiche oder ähnliche Bauteile werden in den Figuren mit gleichen Bezugszeichen gekennzeichnet.

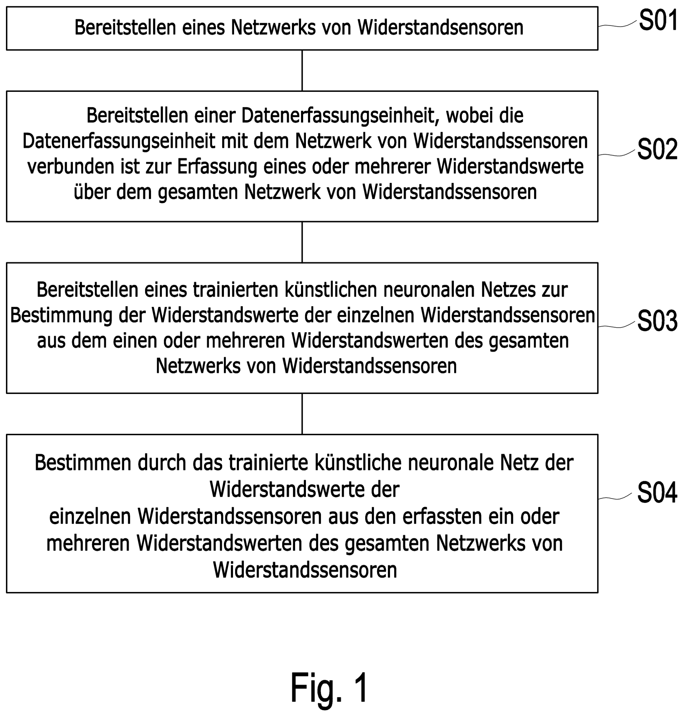

Fig. 1 zeigt eine bevorzugte Ausführungsform der vorliegenden Erfindung für ein Verfahren zur Erfassung von flächigen Messdaten. Im Verfahrensschritt S01 wird zunächst ein Netzwerk von Widerstandssensoren bereitgestellt. Bei dem Netzwerk von Widerstandssensoren handelt es sich bspw. um einen Verbund von einzelnen Widerstandssensoren, vorzugsweise in einem regelmäßigen Vierecksnetz. Weitere mögliche Ausführungsformen der Netztopologie sind in den nachfolgenden Figuren dargestellt.

In einem nächsten Verfahrensschritt S02 wird eine Datenerfassungseinheit bereitgestellt, wobei die Datenerfassungseinheit mit dem Netzwerk von Widerstandssensoren verbunden ist zur Erfassung eines oder mehrerer Widerstandswerte über dem gesamten Netzwerk von Widerstandssensoren. Vorzugseiweise verfügt die Datenerfassungseinheit über mindestens einen Ausgang der mit einer Ausgangskontaktstelle des Netzwerks von Widerstandssensoren verbunden wird und über mindestens einen Eingang der mit einer Eingangskontaktstelle des Netzwerks von Widerstandssensoren verbunden wird.

Im Verfahrensschritt S03 wird ein trainiertes künstliches neuronales Netz in der Datenerfassungseinheit bereitgestellt, zur Bestimmung der Widerstandswerte der einzelnen Widerstandssensoren aus den Widerstandswerten des Netzwerks von Widerstandssensoren.

Das künstliche neuronale Netz wird in einem vorherigen Verfahrensschritt mit einer Datenbank aus einer Vielzahl von Kombinationen von Widerstandswerten der einzelnen Widerstandssensoren mit den dazugehörigen Messwerten der Widerstandswerte des gesamten Netzwerks von Widerstandssensoren trainiert. Vorzugsweise werden synthetischen Daten verwendet, wobei die synthetischen Daten mittels einer Simulation mit einem digitalen Abbild des Netzwerks geniert werden.

Im letzten Verfahrensschritt S04 werden die Widerstandswerte der einzelnen Widerstandssensoren aus den gemessenen Widerstandswerten des gesamten Netzwerks von Widerstandssensoren der Datenerfassungseinheit durch das künstliche neuronale Netz bestimmt. Hierbei werden über die Datenerfassungseinheit die Widerstandswerte als Eingangsdaten für das trainierte künstliche neuronale Netz genutzt, welches als Ausgabe die Widerstandswerte der einzelnen Widerstandssensoren des Netzwerks ermittelt. Hierzu werden insbesondere sequenziell mehrere Widerstandswerte der Datenerfassungseinheit erfasst, wobei jeweils andere Kombinationen von Ausgangs- und/oder Eingangskontaktstellen angesteuert werden.

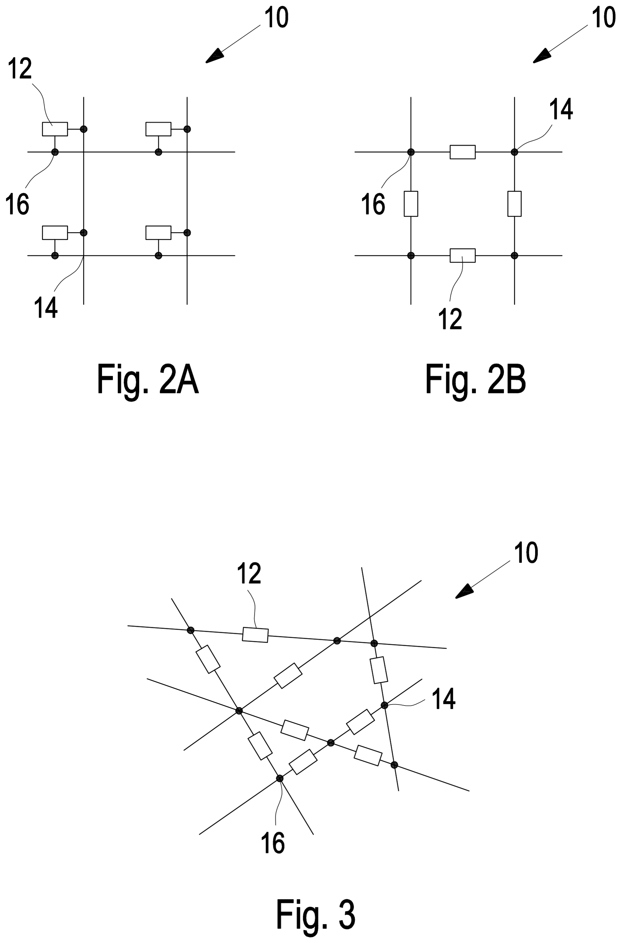

Fig. 2A und 2B zeigen jeweils unterschiedliche Ausführungsformen der Knotenpunkte 14 im Netzwerk 10 von Widerstandssensoren 12. Fig. 2A zeigt eine Anordnung der Widerstandssensoren 12 in einem Netzwerk 10 von Widerstandssensoren 12 parallel zu einem Knotenpunkt 14. Hierbei sind die Widerstandssensoren 12 über separate Kontaktpunkte 16 in dem Netzwerk angeordnet. Somit kann der Messwert am Knotenpunkt 14 erfasst werden. Alternativ können die Widerstandssensoren 12 als Streben oder Verbindungsstücke zwischen den Knotenpunkten 14 des Netzwerks 10 von Widerstandssensoren 12 ausgebbildet sein, wie in Fig. 2B dargestellt. Hierbei fallen die Kontaktpunkt 16 mit den Knotenpunkten 14 des Netzwerks zusammen. Somit werden die Messwerte zwischen den Knotenpunkten 14 erfasst.

In Fig 2B ist das Netzwerk 10 von Widerstandssensoren 12 als regelmäßig geformtes Viereck gemäß einer beispielhaften Ausführungsform der vorliegenden Erfindung ausgebildet. Die Knotenpunkte 14 bilden gemeinsam mit den Kontaktpunkten 16 jeweils die vier Eckpunkte eines Vierecks.

Fig. 3 zeigt eine schematische Darstellung einer chaotischen Netztopologie gemäß einer beispielhaften Ausführungsform der vorliegenden Erfindung. Das Netzwerk 10 von Widerstandssensoren weist hierbei eine Vielzahl an unterschiedlichen Vielecken auf, wobei die Knotenpunkte 14 jeweils die Eckpunkte eines Vielecks bilden und teilweise mit den Kontaktpunkten 16 der Widerstandssensoren 12 zusammenfallen. In der gezeigten beispielhaften Ausführungsform sind die Widerstandssensoren 12 als Verbindungsstücke zwischen zwei Knotenpunkten 14 des Netzwerks 10 gezeigt, wobei das Netzwerk 10 auch Verbindungsstücke ohne Widerstandssensoren umfassen kann.

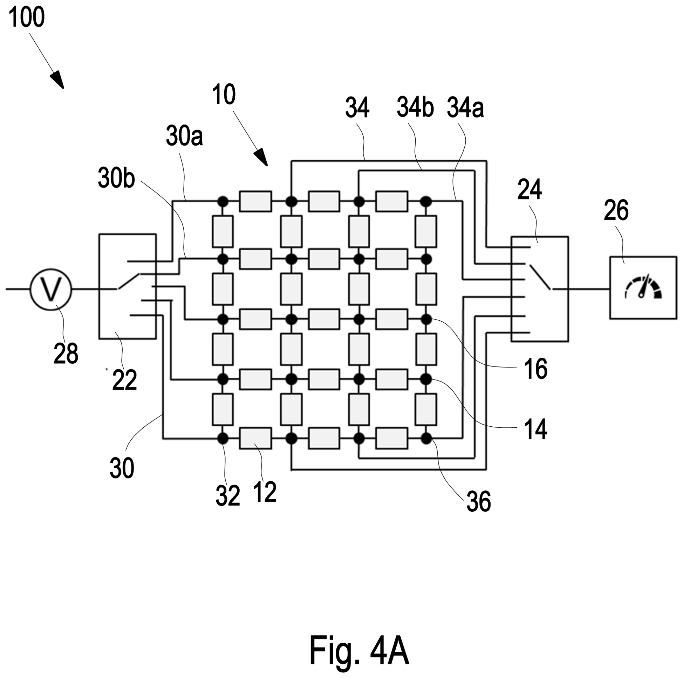

Fig. 4A zeigt in einer schematischen Darstellung einen weiteren Aspekt der vorliegenden Erfindung in einer bevorzugten Ausführungsform für eine Vorrichtung 100 zur flächigen Messdatenerfassung. Hierbei umfasst die Vorrichtung 100 eine Spannungsquelle 28 die an den Eingang eines ersten Multiplexers 22 angeschlossen ist. Der erste Multiplexer 22 ist über einer Vielzahl von Ausgängen 30 an das Netzwerk von Widerstandssensoren 10 und insbesondere Ausgangskontaktstellen 32 des Netzwerks, angeschlossen. Das Netzwerk 10 von Widerstandssensoren 12 umfasst ein regelmäßiges Vierecknetz mit einer Vielzahl an Knotenpunkten 14 und Widerstandssensoren 12 die als Verbindungsstücke zwischen den Knotenpunkten 14 angeordnet sind. Die Kontaktpunkte 16 der Widerstandssensoren fallen in der dargestellten Ausführungsform mit den Knotenpunkten 14 des Netzwerks 10 zusammen. Die vorliegende Erfindung ist nicht auf die gezeigte Netztopologie oder die Anzahl an Knotenpunkten 14 oder Widerstandssensoren 12 beschränkt. Die Anzahl an Widerstandssensoren 12 könnte größer oder kleiner als die dargestellte Anzahl an Widerstandssensoren 12 sein. Entsprechendes gilt für die Knotenpunkte 14, deren Anzahl größer oder kleiner als die gezeigte Anzahl an Knotenpunkten 14 sein kann.

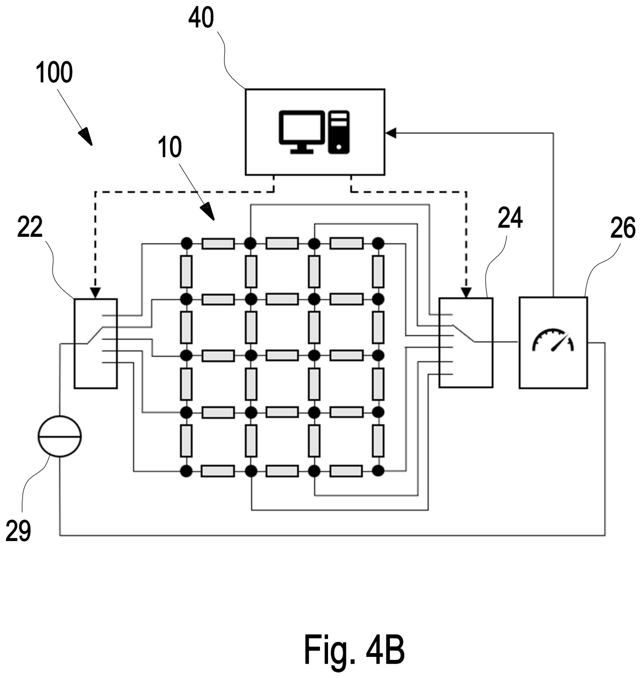

Weiterhin ist ein zweiter Multiplexer 24 gezeigt, wobei der zweite Multiplexer mit seiner Vielzahl an Eingängen 34 mit dem Netzwerk 10 von Widerstandssensoren 12, insbesondere an Eingangskontaktstellen 36 des Netzwerks, verbunden ist. Die Anzahl an Ausgängen 30 des ersten Multiplexers 22 und die Anzahl an Eingängen 34 des zweiten Multiplexers 24 kann verschieden oder gleich sein. Insbesondere kann die Anzahl an Ausgängen 30 des ersten Multiplexers 22 größer oder kleiner als die Anzahl an Eingängen 34 des zweiten Mutliplexers 24 sein. Mit dem Ausgang des zweiten Multiplexers 24 ist eine Messeinheit 26 verbunden zu Erfassung des Widerstandswertes des gesamten Netzwerks 10 zwischen den jeweils angeschlossenen Ausgans- und Eingangskontaktstellen 32, 36. Wie in Fig. 4 beispielhaft gezeigt verbinden der erste Multiplexers 22 und der zweite Multiplexer 24 durch unterschiedliche Kombinationen an Aus- und Eingängen 30, 34 verschiedene Ausgangs- und Eingangskontaktstellen 32, 36 des Netzwerks 10 von Widerstandssensoren 12, so dass eine Vielzahl an unterschiedlichen elektrischen Pfaden im Netzwerk von Widerstandssensoren zwischen der Spannungsquelle 28 und der Messeinheit 26 gebildet wird. Hierbei liegen beispielsweise zwischen einem ersten Anschluss 30a des ersten Multiplexers 22 und einem ersten Anschluss 34a des zweiten Multiplexers 24 der elektrische Pfad mit den drei Widerstandssensoren 12 der obersten Reihe des Netzwerks 10 von Widerstandssensoren 12, wobei zwischen einem zweiten Anschluss 30b des ersten Multiplexers 22 und einem zweiten Anschluss 34b des zweiten Multiplexers 24 ein anderer elektrischer Pfad liegt. Somit können unterschiedliche elektrische Pfade des Netzwerks mit unterschiedlichen Widerstandswerten erfasst werden, ohne dass sich das Netzwerk von Widerstandssensoren 10 ändert. In der exemplarisch dargestellten Ausführungsform sind die Ausgangskontaktstellen 32 verschieden von den Eingangskontaktstellen 36. Es ist jedoch auch möglich, dass eine Ausgangskontaktstelle 32 in einer Messung als Ausgangskontaktstelle 32 und in einer weiteren Messung als Eingangskontaktstelle 36 ausgebildet ist.

In die Messeinheit 26 ist ein trainiertes künstliches neuronales Netz implementiert, welches anhand dem zwischen den jeweiligen Eingangskontaktstellen 32 und Ausgangskontaktstellen 36 gemessenen Widerstandswert, Widerstandswerte für einen, mehrere oder sogar alle Widerstandssensoren 12 in dem Netzwerk 10 ermittelt.

In einer beispielsweisen Messung, wird zunächst ein Ausgang 30 des ersten Multiplexers 22 und ein Eingang 34 des zweiten Multiplexers 24 angesteuert. Nachdem eine Spannung an der Spannungsquelle 28 angelegt wird, kann die Messeinheit 26 einen Widerstand über den Widerstandssensoren 12 zwischen dem angesteuerten Ausgang des ersten Multiplexers 22 bzw. dem Ausgangskontaktstelle 32 und dem angesteuerten Eingang des zweiten Multiplexers 24 bzw. der Eingangskontaktstelle 36 erfassen. In einem nächsten Verfahrensschritt wird beispielsweise ein anderer Ausgang des zweiten Multiplexers 24 angesteuert der mit einer anderen Ausgangskontaktstelle 34 des Netzwerks verbunden ist, so dass ein anderer elektrischer Pfad zwischen dem Ausgang des ersten Multiplexers 22 und dem Eingang des zweiten Multiplexers 24 liegt. Somit wird von der Messeinheit 26 der Widerstandswert über andere Widerstandssensoren erfasst. Alternativ kann statt einer Spannungsquelle 28 auch eine Stromquelle 29 an das Netzwerk von Widerstandssensoren angeschlossen sein (siehe Fig. 4B). Der Widerstandswert kann hierbei ermittelt werden anhand eines Spannungsabfalls über das Netzwerk 10 oder eine Stromänderung. Dieser Vorgang wiederholt sich, insbesondere bis alle Kombinationen von Aus- und Eingängen des ersten 22 bzw. zweiten Multiplexers 24 und somit alle Kombinationen von Ausgangs- und Eingangskontaktstellen des Netzwerks angesteuert wurden und entsprechend eine Vielzahl an Messwerten von der Widerstandsmesseinheit 26 erfasst wurde. Die Kombination der Ausgänge des ersten Multiplexers 22 und der Eingänge des zweiten Multiplexers 24 sowie der zugehörigen Messwerte der Widerstandsmesseinheit 26 bilden ein Muster, welches als Eingangsdaten bzw. Eingangsvektor dem trainierten künstlichen neuronalen Netz zugeführt werden. Auf Basis der Eingangsdaten ermittelt das trainierte künstliche neuronale Netz die Widerstandswerte der einzelnen Widerstandssensoren 12 im Netzwerk 10, wobei über die Widerstandscharakteristik der jeweiligen Widerstandssensoren auf einen weiteren physikalischen Wert an der Messstelle, bspw. eine Temperatur oder ein Druck oder eine Längenausdehnung, geschlossen werden kann. Alternativ kann das trainierte künstliche neuronale Netz bereits den weiteren physikalischen Wert bestimmen. So können beispielsweise mit der in Fig. 4 gezeigten Vorrichtung 100 die Widerstandswerte der 31 einzelnen Widerstandssensoren 12 des Netzwerks 10 über die dargestellten 5 Ausgänge 30 des ersten Multiplexers 22 und 6 Eingänge 34 des zweiten Multiplexers 24 mit 30 oder weniger Messungen, beispielsweise sequenziellen Messungen, erfasst werden.

Fig. 4B zeigt schematisch eine weitere Ausführungsform der vorliegenden Erfindung für eine Vorrichtung 100 zur flächigen Messdatenerfassung. Zusätzlich zur Fig. 4A ist in Fig. 4B eine Steuereinheit 40 dargestellt und anstatt einer Spannungsquelle 28 eine Stromquelle 29, wobei die Steuereinheit die Stromquelle 29, die Multiplexer 22 und 24, die Messeinheit 26 sowie das trainierte künstliche neuronale Netz zur Bestimmung der Widerstandswerte der einzelnen Widerstandssensoren 12 des Netzwerks 10 steuern kann. Alternativ kann statt einer Stromquelle 29 auch eine Spannungsquelle 28 an das Netzwerk von Widerstandssensoren angeschlossen sein.

## Patentansprüche

1. Verfahren zur Erfassung von flächigen Messdaten, insbesondere von einer flächigen Temperaturverteilung, aufweisend die Schritte:
Bereitstellen eines Netzwerks von einzelnen Widerstandsensoren;
Bereitstellen einer Datenerfassungseinheit, wobei die Datenerfassungseinheit mit dem Netzwerk von Widerstandssensoren verbunden ist zur Erfassung eines oder mehrerer Widerstandswerte über dem gesamten Netzwerk von Widerstandssensoren;
Bereitstellen eines trainierten künstlichen neuronalen Netzes zur Bestimmung der Widerstandswerte der einzelnen Widerstandssensoren aus dem einen oder mehreren Widerstandswerten des gesamten Netzwerks von Widerstandssensoren; und
Bestimmen durch das künstliche neuronale Netz der Widerstandswerte der einzelnen Widerstandssensoren aus den erfassten einen oder mehreren Widerstandswerten des gesamten Netzwerks von Widerstandssensoren.

2. Verfahren nach Anspruch 1, wobei die Datenerfassungseinheit einen oder mehrere Ausgänge und einen oder mehrere Eingänge umfasst und der eine oder die mehreren Ausgänge mit entsprechenden Ausgangskontaktstellen des Netzwerks verbunden sind und der eine oder die mehreren Eingänge der Datenerfassungseinheit mit entsprechenden Eingangskontaktstellen des Netzwerks verbunden sind.

3. Verfahren nach Anspruch 2, wobei die ein oder mehreren Ausgänge der Datenerfassungseinheit durch einen ersten Multiplexer bereitgestellt werden und die ein oder mehreren Eingänge der Datenerfassungseinheit durch einen zweiten Multiplexer bereitgestellt werden.

4. Verfahren nach Anspruch 2 oder 3, wobei das Verfahren zusätzlich die Schritte umfasst:
Messen mindestens eines oder mehrerer Widerstandswerte des gesamten Netzwerks von Widerstandssensoren; und
Wiederholen der Messung bei unterschiedlichen Kombinationen der Ausgangskontaktstellen und Eingangskontaktstellen des Netzwerks von Widerstandssensoren.

5. Verfahren nach einem der Ansprüche 1 bis 4, wobei die Bereitstellung des trainierten künstlichen neuronalen Netzes zusätzlich die Schritte umfasst:
Bereitstellen eines digitalen Abbildes des Netzwerks von Widerstandssensoren;
Generieren einer Datenbank aus einer Vielzahl von unterschiedlichen Widerstandswerten der einzelnen Widerstandssensoren mit den dazugehörigen Widerstandswerten des gesamten Netzwerks von Widerstandssensoren mittels Simulation mit dem digitalen Abbild des Netzwerks;
Bereitstellen eines untrainierten künstlichen neuronalen Netzes; und
Trainieren des künstlichen neuronalen Netzes mit den Widerstandswerten des gesamten Netzwerks von Widerstandssensoren und den Widerstandswerten der einzelnen Widerstandssensoren aus der Datenbank.

6. Verfahren nach einem der Ansprüche 1 bis 5, wobei die Datenerfassungseinheit zusätzlich eine Spannungsquelle oder eine Stromquelle umfasst.

7. Verfahren nach einem der Ansprüche 1 bis 6, wobei die Widerstandssensoren parallel zu einem Knotenpunkt des Netzwerks von Widerstandssensoren ausgebildet sind oder die Widerstandssensoren als Verbindungsstücke zwischen den Knotenpunkten des Netzwerks von Widerstandssensoren ausgebbildet sind.

8. Verfahren nach einem der Ansprüche 1 bis 7, wobei die Widerstandssensoren als Widerstandsthermometer zur Erfassung von Temperaturen ausgebildet sind.

9. Verfahren nach einem der Ansprüche 1 bis 7, wobei die Widerstandssensoren als Dehnmessstreifen zur Erfassung von Dehnungen ausgebildet sind.

10. Verfahren nach einem der Ansprüche 1 bis 7, wobei die Widerstandssensoren als Drähte zur Erfassung von strukturellem Versagen oder Rissen ausgebildet sind.

11. Verfahren nach einem der Ansprüche 1 bis 7, wobei die Widerstandssensoren als Druck- oder Kontaktsensoren zur Erfassung von Bauteilberührungen oder bei Beaufschlagungen mit Gasdruck ausgebildet sind.

12. Verfahren nach einem der Ansprüche 1 bis 11, wobei eine Netztopologie des Netzwerks von Widerstandssensoren als regelmäßig geformtes Viereck oder regelmäßig geformtes beliebiges Netzwerk oder als chaotisches Netzwerk ausgebildet ist.

13. Vorrichtung mit einer implementierten Datenerfassungseinheit nach einem der Ansprüche 1 bis 12 zur Erfassung von flächigen Messdaten.
